# EUROPÄISCHE PATENTSCHRIFT

(11) **EP 4 004 833 B1**
(45) Veröffentlichungstag und Bekanntmachung des Hinweises auf die Patenterteilung: **26.03.2025**
(21) Anmeldenummer: 20743676.7
(22) Anmeldetag: 20.07.2020
(51) Int. Cl.: G06N 10/40, H01L 21/02, H01L 29/16, H01L 29/66, B82Y 10/00, H01L 29/40

(54) **VERFAHREN UND VORRICHTUNG ZUR ADRESSIERUNG VON QUBITS SOWIE VERFAHREN ZUR HERSTELLUNG DER VORRICHTUNG**
METHOD AND DEVICE FOR ADDRESSING QUBITS, AND METHOD FOR PRODUCING THE DEVICE
PROCÉDÉ ET DISPOSITIF D'ADRESSAGE DE QUBITS ET PROCÉDÉ DE FABRICATION DU DISPOSITIF

(30) Priorität: 31.07.2019 DE 102019120716
(43) Veröffentlichungstag der Anmeldung: 01.06.2022
(73) Patentinhaber: Quantum Technologies GmbH, 04103 Leipzig (DE)
(72) Erfinder: MEIJER, Jan Berend, 44892 Bochum (DE); JOHN, Roger, 04317 Leipzig (DE); STAACKE, Robert, 04317 Leipzig (DE)
(74) Vertreter: Hecht, Jan-David
(86) Internationale Anmeldenummer: PCT/EP2020/070485
(87) Internationale Veröffentlichungsnummer: WO 2021/018654

(56) Entgegenhaltungen:
- DE-A1- 102009 033 566
- DE-A1- 102010 053 575
- US-A1- 2005 167 772
- GARELLI M S ET AL: "Buckyball Quantum Computer: Realization of a Quantum Gate", ARXIV.ORG, CORNELL UNIVERSITY LIBRARY, 201 OLIN LIBRARY CORNELL UNIVERSITY ITHACA, NY 14853, 14 January 2005 (2005-01-14), XP080189373, DOI: 10.1140/EPJB/E2005-00397-6
- LILIAN CHILDRESS ET AL: "Diamond NV centers for quantum computing and quantum networks", M R S BULLETIN, vol. 38, no. 2, 1 February 2013 (2013-02-01), US, pages 134 - 138, XP055738266, ISSN: 0883-7694, DOI: 10.1557/mrs.2013.20
- MICHAEL SCOTT WOLF: "COUPLING NITROGEN-VACANCY CENTER SPINS IN DIAMOND TO A FERROMAGNETIC VORTEX", 6 June 2017 (2017-06-06), XP055738251, Retrieved from the Internet <URL:https://etd.ohiolink.edu/!etd.send_file?accession=case1491817964933604&disposition=inline> [retrieved on 20201009]

## Beschreibung

Die vorliegende Erfindung betrifft ein Verfahren zur Adressierung von Qubits nach dem Oberbegriff von Anspruch 1, eine Vorrichtung zur Adressierung von Qubits nach dem Oberbegriff von Anspruch 5 und ein Verfahren zur Herstellung der Vorrichtung nach dem Oberbegriff von Anspruch 13.

Quantencomputer bieten die Möglichkeit, spezielle Probleme mithilfe von quantenmechanischen Effekten zu lösen. Der Unterschied zu einem handelsüblichen Computer besteht hierbei in der Verwendung von Quantenbits (Qubits), diese stellen das Äquivalent zu Bits in einem klassischen Computer dar.

Die Betrachtung von Bits zeigt, dass diese nur zwei Zustände einnehmen können. Diese beiden Zustände sind 0 und 1. Qubits dagegen können nicht nur den Zustand 0 und 1 einnehmen, sondern auch innerhalb einer bestimmten Zeitspanne (Kohärenzzeit) einen Zwischenzustand aus 0 und 1 einnehmen. Dieser Zustand wird als Superposition bezeichnet. Im Gegensatz zu den klassischen Bits heutiger Computer können Qubits somit viel mehr Informationen verarbeiten und bieten daher das Potenzial für Computer mit nie dagewesener Rechenkapazität. Besonders die Herstellung solcher Qubits ist derzeit ein Thema in der Wissenschaft, in das viel Forschungsarbeit investiert wird. Wissenschaftler suchen nach dem besten Weg, Qubits herzustellen und sie gemäß der Quantengesetze zu Recheneinheiten miteinander zu verbinden.

Eine Realisierung von Qubits kann derzeit durch unterschiedliche Methoden erfolgen. Bekannt sind supraleitende Qubits, die leicht aufzubauen und skalierbar sind. Es wurden so schon bis zu 20 Qubits verschränkt. Allerdings bestehen nur extrem kurze T2-Zeiten (Transversale Relaxationszeit - Spin-Spin Relaxation) und es muss eine Kühlung auf 4°K (-273°C) sichergestellt werden, weshalb die die Computer in extra dafür bereitgestellten Räumen installiert werden müssen, um die Kühlung und einen möglichst hohen Schutz vor Erschütterungen, elektrischen Streufeldern und Restwärme zu gewährleisten.

Qubits über Ionenfallen sind gut zu kontrollieren und besitzen extrem lange T2-Zeiten. Es wurden so schon zwischen 10 und 20 Qubits verschränkt. Allerdings sind sie nicht skalierbar und technisch sehr aufwendig.

Es wurden auch schon NMR Quantencomputer untersucht, wobei 5 Qubits verschränkt wurden. Diese zeichnen sich durch eine sehr einfache Programmierung aus, allerdings sind sie nicht skalierbar und die dahinter stehende Technik ist sehr aufwendig.

Festkörperbasierte Quantenbits sind bisher die einzige Möglichkeit, die oben genannten Nachteile zu umgehen, denn ein Quantencomputer betrieben mit festkörperbasierten Qubits ermöglicht den Betrieb bei Raumtemperatur. Außerdem ist er skalierbar und CMOSkompatibel, weshalb eine gute Anbindung an bisher genutzte Halbleitertechniken möglich ist.

Die vorliegende Erfindung geht von solchen festkörperbasierten Qubits aus. Die zurzeit erfolgversprechendste Variante der festkörperbasierten Qubits besteht in der Nutzung von Stickstoff-Fehlstellen-Zentren (NV-Zentren) in Diamanten.

Diamanten bieten verschiedene mechanische Besonderheiten, wie die sehr hohe Härte, Wärmeleitfähigkeit und Reaktionsbeständigkeit. Die Forschung hat es in den letzten Jahren geschafft, das Herstellen von Diamanten über chemische Gasphasenabscheidung (CVD) zu ermöglichen. Die synthetische Herstellung bietet den Vorteil, dass Diamanten mit hoher Isotopenreinheit und bestimmten Kristalldefekten erstellbar sind. Die Diamanten können dadurch mit anwendungsspezifischen optischen und elektronischen Attributen ausgestattet werden. Diese nun festlegbaren Attribute der Diamanten sind für die Quantenmechanik von hoher Wichtigkeit und finden dort ein großes Anwendungsgebiet.

Ein zwei dimensionales Gitter von NV Zentren kann in synthetischen Diamanten erzeugt werden. Die Kernspins der Stickstoffatome fungieren dabei als Qubits; Auslese und Kopplung erfolgen über den elektronischen Spin des NV-Zentrums, wobei die Kopplung durch die magnetische Dipolwechselwirkung erreicht wird; inhomogene Magnetfelder ermöglichen die individuelle Quanten Gatter- und parallele Gatter Operation auf vielen Qubits. Allerdings stellt vor allem die Adressierung individueller Gatter-Operationen und Auslesung der einzelnen Qubits ein Problem dar.

Die Ermöglichung einer lokalen Adressierung (Verschiebung der Resonanzfrequenz um mindestens eine Linienbreite) erfolgt in der Regel durch die Verwendung von Magnetfeldern oder unterschiedlichen Orientierungen der Qubits. Die notwendige Verschiebung hängt von der T2-Zeit ab. Problematisch ist dabei, dass bei angewandtem Resonanzverschieben der Einfluss benachbarter Qubits, ein sogenanntes Crossover bzw. Crosstalk, nicht vollständig vermieden werden kann.

Eine Alternative stellt die optische Adressierung dar, wie sie beispielsweise in der US 9 317 473 B2 beschrieben wird. Dabei erfolgt die Adressierung auf optischem Wege. Damit kein Übersprechen zwischen verschiedenen Qubits (Registern) erfolgt, müssen diese ausreichend weit beabstandet (400 nm bis 500 nm) angeordnet werden. Für diese Abstände kann allerdings keine direkte Verschränkung der Qubits erfolgen, so dass eine Vermittlung der Verschränkung über eine sogenannte Dunkle Spin-Kette (dark spin chain) von optisch nicht adressierbaren Spins verwendet werden muss. Wenn dagegen der Abstand ausreichend klein ist, dass eine direkte Verschränkung erfolgen kann, dann wird die Adressierung über Nahfeldmikroskopie (Spin-Resolft) erfolgen. Die indirekte Verschränkung beinhaltet allerdings Funktionsrisiken und der Einsatz der Nahfeldmikroskopie für jedes einzelne Register ist sehr aufwendig. Außerdem ist in beiden Fällen ein Crosstalk (Übersprechen) nicht ausgeschlossen ausgeschlossen. Eine optische Adressierung von Qubits ist ebenfalls aus DE 10 2009 033566 A1 bekannt.

Es ist daher Aufgabe der vorliegenden Erfindung, die Adressierung von Qubits auf einfache Art und Weise zu ermöglichen, ohne dass die Gefahr des Übersprechens besteht. Insbesondere soll auch ein leichtes Auslesen der Qubits möglich sein.

Diese Aufgabe wird gelöst mit dem erfindungsgemäßen Verfahren nach Anspruch 1, der erfindungsgemäßen Vorrichtung nach Anspruch 5 und dem erfindungsgemäßen Herstellungsverfahren für die Vorrichtung nach Anspruch 13. Vorteilhafte Weiterbildungen sind in den Unteransprüchen und in der nachfolgenden Beschreibung zusammen mit den Figuren angegeben.

Erfinderseits wurde erkannt, dass diese Aufgabe in überraschender Art und Weise dadurch gelöst werden kann, dass die Adressierung eines Qubits über ein elektromagnetisches Feld erfolgt, wobei die nicht zu adressierenden Qubits durch angepasste elektromagnetische Gegenfelder abgeschirmt werden. Dadurch kann eine sehr präzise und zugleich einfache Adressierung jedes einzelnen Qubits einer Menge von zwei oder mehr Qubits erfolgen, auch wenn diese zum Zwecke einer direkten Verschränkung relativ nah bei einander angeordnet sind.

Das erfindungsgemäße Verfahren des Adressierens zumindest eines Qubits in einer Menge von zwei und mehr Qubits ist dadurch gekennzeichnet, dass das zu adressierende Qubit einem elektromagnetischen Feld ausgesetzt wird, während zumindest ein anderes Qubit der Menge Qubits einem elektromagnetischen Gegenfeld so ausgesetzt wird, dass das elektromagnetische Feld keine Wirkung auf das andere Qubit hat (zum Zwecke der reinen Abschirmung dieses anderen Qubits) oder dass das elektromagnetische Feld eine andere Wirkung auf das andere Qubit hat als auf das zu adressierende Qubit (zum Zwecke einer unterschiedlichen Adressierung). Im Rahmen der vorliegenden Erfindung wird unter "Adressierung" nicht nur die Auswahl eines Qubits zur Änderung seines Zustandes versta n-den, sondern auch die eigentliche Änderung seines Zustandes im Rahmen einer Quantum Gatter-Operation (auch Quantum Gate Operationen genannt). Als Gatter-Operationen kommen Single-Gate oder Zwei- oder Mehr-Gate Operationen in Frage; letzteres erfolgt meistens in Abhängigkeit vom Zustand eines Qubits (Beispiel CNOT Gate). Das erfindungsgemäße "Verfahren zur Adressierung eines Qubits" ist somit genauer gesagt ein "Verfahren zur Auswahl eines Qubits und/oder zur Änderung des Zustands eines Qubits".

Die Adressierung erfolgt somit über die Auswahl der gewünschten Qubits und der Ausführung von Quanten Gatter Operationen auf diesen Qubits. Währenddessen werden die anderen Qubits abgeschirmt bzw. die Gegenfelder so angepasst, dass darauf eigene Quanten Gatter Operationen optimiert werden.

Quatum Gate Operationen basieren z.B. auf die Änderung des Spin-Zustandes des Qubits durch Einwirkung eines zeitlich variierenden Magnetfeldes einer bestimmten Dauer. Dabei ist die Pulsform so eingestellt, dass ein wohldefinierten Zustand mit geringer Fehlerrate erreicht wird. Bei verschränkten Qubits, zur Steuerung von Register oder zur Fehlerkorrektur können mehrere Qubits gleichzeitig adressiert werden. Typischerweise werden für die Pulsformen eine Trägerfrequenz in einem Frequenzbereich von 500MHz bis zu 50 Ghz für Elektronenspinsysteme und ein Frequenzbereich von 1kHz- 100 MHz für nukleare Spinsysteme genutzt.

Das genaue Vorgehen bei den Quatum Gate Operationen ist nicht Gegenstand dieser Erfindung. Es kann beispielsweise dem Artikel "Protecting a Diamond Quantum Memory by Charge State Control" von M. Pfender et al., Nano Lett. 2017, 17, 10, 5931-5937, entnommen werden, deren diesbezüglicher Inhalt hiermit vollumfänglich aufgenommen wird.

Die elektromagnetischen Felder und die elektromagnetischen Gegenfelder werden dabei in Abhängigkeit von der elektromagnetischen Quelle und der Lage der Qubits in Bezug auf diese Quelle speziell abgestimmt, um jeweils für die Qubits die jeweils gewünschte Adressierung oder Nichtadressierung zu erreichen.

Durch die Linearität der Maxwellgleichungen können so unterschiedliche individuelle Adressierungen jedes einzelnen Qubits erfolgen. Im Detail können folgende Adressierungsarten verwirklicht werden:
- jedes Qubit kann gesondert zu einem bestimmten Zeitpunkt adressiert werden, während die anderen Qubits nicht adressiert werden,
- zwei und mehr Qubits können gleichzeitig identisch adressiert werden, während die anderen Qubits nicht adressiert werden,
- zwei und mehr Qubits können gleichzeitig unterschiedlich adressiert werden, während die übrigen Qubits nicht adressiert werden,
- zwei und mehr Qubits können gleichzeitig identisch adressiert werden, während gleichzeitig zumindest ein weiteres Qubit unterschiedlich adressiert wird und die übrigen Qubits nicht adressiert werden,
- zwei und mehr Qubits können gleichzeitig identisch adressiert werden, während die restlichen Qubits gleichzeitig unterschiedlich adressiert werden
- alle Qubits können gleichzeitig unterschiedlich adressiert werden.

Dabei findet durch die jeweils für jedes Qubit in Bezug auf die Adressierung der anderen Qubits speziell angepassten elektromagnetischen Gegenfelder kein Übersprechen zwischen der Adressierung der Qubits statt.

Jedes Qubit kann somit mit elektromagnetischen Feldern und elektromagnetischen Gegenfeldern zur selben Zeit beaufschlagt werden, wobei durch die Superposition der elektromagnetischen Felder und elektromagnetischen Gegenfelder zugleich die gewünschte Quantum Gatter Operation und Abschirmung erfolgt. Dabei muss nicht das elektromagnetische Feld selbst exakt einer Quantum Gatter-Operation auf dem einen Qubit und das elektromagnetische Gegenfeld exakt der Abschirmung des anderen Qubits dienen, sondern es sind Mischformen möglich, so können beispielsweise auch das elektromagnetische Feld des einen Qubits und das elektromagnetische Gegenfeld des anderen Qubits zur Realisierung der Quantum-Gatter-Operation des anderen Qubits verwendet werden.

In einer vorteilhaften Weiterbildung ist vorgesehen, dass das elektromagnetische Feld und das elektromagnetische Gegenfeld amplitudenmoduliert sind, wobei eine zeitliche Variation zwischen der Modulation des elektromagnetischen Feldes und des elektromagnetischen Gegenfeldes besteht. Dadurch ist das Verfahren besonders einfach und effektiv umsetzbar.

Das elektromagnetische Feld und das elektromagnetische Gegenfeld werden als elektromagnetische Nahfelder verwendet, wobei die elektromagnetischen Nahfelder bevorzugt magnetische Nahfelder sind, die insbesondere eine Frequenz im Mikrowellenbereich und/oder oder Kilohertzbereich aufweisen. Elektromagnetische Nahfelder koppeln sehr gut an benachbarte Qubits an, wobei es aufgrund der Laplace-Gleichungen zu einer maximalen Feldüberhöhung in der Nähe der Quelle des elektromagnetischen Nahfeldes kommt. Diese Nahfelder sind una b-hängig von der Wellenlänge des verwendeten elektromagnetischen Feldes bzw. Gegenfelds und lassen sich durch Überlagerung lokal verstärken bzw. begrenzen. Felder im Kilohertzbereich (Bereich 0 kHz bis 1 GHz) können zur Adressierung der Kernspins verwendet werden, während Felder im Mikrowellenbereich (Bereich 0 GHz bis 50 GHz, bevorzugt im Bereich 2,87 GHz) zur Adressierung der Elektronenspins verwendet werden können.

Als Qubits werden NV-Zentren im Diamant verwendet. Diese lassen sich besonders einfach und mit hohen Umwandlungsraten herstellen, wie in der DE 10 2019 117 423.6 gezeigt ist, deren diesbezüglicher Inhalt hiermit vollumfänglich einbezogen wird.

In einer vorteilhaften Weiterbildung ist vorgesehen, dass zur Bereitstellung der elektromagnetischen Felder und Gegenfelder elektromagnetische Quellen, bevorzugt elektrisch leitfähige Strukturen, verwendet werden, die einzelnen Qubits zugeordnet sind. Dadurch können die elektromagnetischen Felder und Gegenfelder besonders einfach lokal jedem einzelnen Qubit zugewiesen werden.

In einer vorteilhaften Weiterbildung ist vorgesehen, dass die elektrisch leitfähigen Strukturen als Leitungen, Metallisierungen, Drähte oder dgl. für ein elektromagnetisches Feld, bevorzugt ein elektromagnetisches Hochfrequenzfeld bereitgestellt werden. Die leitfähigen Strukturen sollten dazu insbesondere Hochfrequenz übertragungsfähig sein. Vorzugsweise besitzen dazu die leitfähigen Strukturen eine kleinere Dimension (Durchmesser - die Länge kann größer sein) als der Abstand benachbarter Qubits. Dadurch kann das Verfahren besonders einfach umgesetzt werden.

In einer bevorzugten Ausgestaltung werden als Qubits Farbzentren verwendet, wobei die elektromagnetischen Felder und elektromagnetischen Gegenfelder durch elektrisch leitfähige Strukturen bereitgestellt werden, die eine kleinere Dimension besitzen als der Abstand benachbarter Qubits. Dadurch lassen sich die Qubits besonders einfach addressieren.

In einer vorteilhaften Weiterbildung ist vorgesehen, dass eine zur Anzahl an Qubits identische Anzahl an leitfähigen Strukturen besteht, wodurch die Adressierung besonders einfach möglich ist.

Allerdings muss nicht zwingend eine zur Anzahl der Qubits identische Anzahl an leitfähigen Strukturen bestehen, weil die Felder aus unterschiedlichen leitfähigen Strukturen überlagert werden können und auch Gradientenfelder gebildet werden können. Damit das System nicht unterbestimmt ist, könnten man auf den leitfähigen Strukturen ein zusätzliches elektrischen quasistatisches Feld erzeugen und z.B. über den Starkeffekt oder den Zeemaneffekt eine Adressierung erreichen. Dies führt zu einer definierten Frequenzverschiebung und macht die anderen Qubits für die elektromagnetischen Felder quasi unsichtbar. In dem einfachsten Fall legt man an einer Leitung einen definierten Bias an (z.B. 10V) und nur am Kreuzungspunkt addieren sich die Spannungen (20V) und führen zu der abgestimmt Frequenz des elektromagnetischen Feldes. Dadurch wäre es beispielsweise auch möglich, an zwei oder drei Qubits gleichzeitig Quanten Gatter Operationen durchzuführen. Eventuell auftretende Fehler durch mit Biasänderungen verbundenen Pulsen könnten dann über mehre zeitlich getrennte Pulsfolgen korrigiert werden.

So könnte ein Feld von beispielsweise 9 Qubits, die als orthogonales 3 x 3 Raster in einer Ebene angeordnet sind, durch 6 erste elektrisch leitfähige Drähte adressiert werden, die in zwei Ebenen bestehen, wobei jede Ebene 3 parallel zueinander angeordnete erste elektrisch leitfähige Drähte aufweist; die Drähte einer Ebene orthogonal zu den Drähten der anderen Ebene liegen und die einzelnen Drähte voneinander elektrisch isoliert angeordnet sind. Vorzugsweise laufen die Drähte jeweils parallel zu einer Linie von Qubits. Allgemein gesprochen können Raster von X * Y Qubits durch zumindest zwei Ebenen von jeweils zumindest X Leitungen bzw. Y Leitungen adressiert werden. Das Raster und die Drähte müssen dabei nicht zwingend orthogonal angeordnet sein, sie können auch schräg angeordnet sein. Die Adressierung wird in diesem Fall beispielsweise durch ein elektrisches Feld über den Starkeffekt erreicht oder durch einen semistatisches Magnetfeld über den Zeemanneffekt. In beiden Fällen wird die Resonanzfrequenz der Qubits verändert, was wiederum zu Auswahleffekt führt.

Andererseits könnte bei einer dreidimensionalen orthogonalen oder schrägen Anordnung der Qubits (X * Y *Z) die Adressierung durch zumindest drei orthogonal oder schräg zueinander stehende Ebenen von zumindest X, Y und Z Drähten erfolgen. Auch hier laufen die Drähte vorzugsweise parallel zu einer Linie von Qubits.

Grundsätzlich reicht es somit, wenn für jedes Qubit eine gesonderte elektrisch leitfähige Struktur, beispielsweise Draht, Leitung oder Metallisierung, besteht. Durch Anordnung der Qubits in 2- oder 3-dimensionalen Rastern kann die Anzahl der notwendigen elektrisch leitfähigen Strukturen aber reduziert werden. Die einzelnen elektrisch leitfähigen Strukturen müssen dabei in jedem Fall elektrisch voneinander isoliert angeordnet sein, was beispielsweise durch ein Isolatormaterial innerhalb einer Ebene zwischen einzelnen elektrisch leitfähigen Strukturen und eine Isolatorschicht zwischen verschiedenen Ebenen mit elektrisch leitfähigen Strukturen erreicht werden kann.

Die elektromagnetischen Quellen bzw. leitfähigen Strukturen können gleichzeitig zum Auslesen der Qubits verwendet werden, wozu beispielsweise mittels eines Lichtpulses Photoelektronen in dem auszulesenden Qubit erzeugt und über die elektromagnetischen Quellen bzw. leitfähigen Strukturen erfasst werden. Hierzu sollte noch zusätzliche zumindest eine Erdung bereitgestellt werden. Diese Erdung kann beispielsweise als Rückseitenkontakt einer dünnen Schicht bestehen, wobei die die Qubits in der dünnen Schicht vorliegen, oder es bestehen ein oder mehrere weitere leitfähige Strukturen, die geerdet sind.

Das genaue Vorgehen bei der Auslesung ist nicht Gegenstand dieser Erfindung. Es kann beispielsweise dem Artikel "Photoelectrical imaging and coherent spin-state readout of single nitrogen-vacancy centers in diamond" von P. Siyushev et al., Science, 363, 6428, 728-731 entnommen werden, deren diesbezüglicher Inhalt hiermit vollumfänglich aufgenommen wird.

In einer vorteilhaften Weiterbildung ist vorgesehen, dass die Qubits in einem transparenten Material bestehen, so dass eine Formatierung der Qubits, bevorzugt eine gleichzeitige Formatierung mehrerer, insbesondere aller Qubits, mittels einer optischer Strahlung, vorzugsweise einer LASER-Strahlung, erfolgen kann, so wie es beispielsweise ebenfalls in dem Artikel "Photoelectrical imaging and coherent spin-state readout of single nitrogen-vacancy centers in diamond" von P. Siyushev et al., Science, 363, 6428, 728-731 entnommen beschrieben ist, deren diesbezüglicher Inhalt hiermit vollumfänglich aufgenommen wird. Wenn leitfähige Strukturen als elektromagnetische Quellen verwendet werden, dann sollten diese möglichst transparent ausgebildet sein, um die Bestrahlung nicht zu verschatten. Es könnte sich beispielsweise um Leitungen oder Drähte aus einem Metalloxid, wie ITO (Indium-Zink-Oxid) handeln. Im Fall nicht transparenter leitfähiger Strukturen können diese so dimensioniert werden, dass die Bestrahlung durch Beugung das entsprechende Qubit erreichen kann.

Selbständiger Schutz wird beansprucht für die erfindungsgemäße Vorrichtung zur Adressierung zumindest eines Qubits in einer Menge von zwei oder mehr Qubits, die dadurch gekennzeichnet ist, dass Mittel zur Erzeugung eines elektromagnetischen Feldes bestehen, die so ausgebildet sind, dass das zu adressierende Qubit dem elektromagnetischen Feld ausgesetzt werden kann, und dass Mittel zur Erzeugung zumindest eines elektromagnetischen Gegenfelds bestehen, die so ausgebildet sind, dass zumindest ein anderes Qubit der Menge Qubits dem elektromagnetischen Gegenfeld so ausgesetzt werden kann, dass das elektromagnetische Feld des zu adressierenden Qubits keine Wirkung auf das andere Qubit hat oder dass das elektromagnetische Feld eine andere Wirkung auf das andere Qubit hat als auf das zu adressierende Qubit.

In einer vorteilhaften Weiterbildung ist vorgesehen, dass die Vorrichtung angepasst ist, das erfindungsgemäße Verfahren durchzuführen.

In einer vorteilhaften Weiterbildung ist vorgesehen, dass erste elektromagnetische Quellen, bevorzugt erste elektrisch leitfähige Strukturen, insbesondere Leitungen, Drähte, Metall i-sierungen und dgl., zur Erzeugung der elektronmagnetischen Felder und der elektromagnetischen Gegenfelder bestehen, wobei jedem Qubit zumindest eine elektromagnetische Quelle, bevorzugt eine erste elektrisch leitfähige Struktur, zugeordnet ist. Dadurch können die elektromagnetischen Felder und Gegenfelder besonders einfach den einzelnen Qubits zugewiesen werden.

In einer vorteilhaften Weiterbildung ist vorgesehen, dass mehrere erste elektromagnetische Quellen, bevorzugt erste elektrisch leitfähige Strukturen, insbesondere in der Form von Drähten, in einer Ebene angeordnet sind, wobei die Qubits einen Abstand senkrecht zu dieser Ebene von ihrer jeweils zugeordneten elektromagnetischen Quelle von höchstens 30 nm, bevorzugt von höchstens 20 nm, insbesondere im Bereich 0 nm bis 10 nm aufweisen. Dadurch lassen besonders einfach elektromagnetische Nahfelder erzeugen, die sehr stark an das benachbarte Qubit ankoppeln, wobei es aufgrund der Laplace-Gleichungen zu einer maximalen Feldüberhöhung kommt. Diese Nahfelder sind unabhängig von der Wellenlänge des verwendeten elektromagnetischen Feldes bzw. Gegenfelds und lassen sich durch Überlagerung lokal verstärken bzw. begrenzen.

In einer vorteilhaften Weiterbildung ist vorgesehen, dass zumindest eine erste elektrisch leitfähige Struktur wahlweise mit einer elektromagnetischen Anregung oder einer Photoelektronenerfassung verbindbar ist. Dadurch können die elektrisch leitfähigen Strukturen sowohl zur Adressierung als auch zur Auslesung verwendet werden.

In einer vorteilhaften Weiterbildung ist vorgesehen, dass mehrere erste elektromagnetische Quellen, bevorzugt erste elektrisch leitfähige Strukturen, insbesondere in der Form von Drähten, in einer Ebene angeordnet sind, wobei die Qubits projiziert auf diese Ebene einen Abstand von der jeweils zugeordneten ersten elektromagnetischen Quelle von höchstens 20 nm, bevorzugt von höchstens 10 nm, insbesondere im Bereich 0 nm bis 5 nm aufweisen. Auch dadurch lassen besonders einfach elektromagnetische Nahfelder erzeugen, die sehr stark an das benachbarte Qubit ankoppeln, wobei es aufgrund der Laplace-Gleichungen zu einer maximalen Feldüberhöhung kommt. Diese Nahfelder sind unabhängig von der Wellenlänge des verwendeten elektromagnetischen Feldes bzw. Gegenfelds und lassen sich durch Überlagerung lokal verstärken bzw. begrenzen.

In einer vorteilhaften Weiterbildung ist vorgesehen, dass zumindest eine zweite elektrische leitfähige Struktur, bevorzugt ein zweiter elektrisch leitfähiger Draht, eine Leitung oder eine Metallisierung oder eine Elektrode besteht, die die Erdung für das Auslesen der Qubits bildet, wobei die zweite elektrisch leitfähige Struktur bevorzugt benachbart zu einer ersten elektromagnetischen Quelle angeordnet ist, insbesondere in einem Abstand in einer Ebene von höchstens 40 nm, bevorzugt höchstens 30 nm, insbesondere in einem Bereich von 10 nm bis 20 nm.

In einer vorteilhaften Weiterbildung ist vorgesehen, dass zumindest eine zweite elektrisch leitfähige Struktur als Rückseitenkontakt einer relativ dünnen Schicht besteht, wobei sich für Diamant eine Schichtdicke von höchstens 100 nm, bevorzugt höchstens 80 nm, insbesondere höchstens 60 nm, empfiehlt. Dadurch erfolgt das Auslesen besonders effizient.

In einer vorteilhaften Weiterbildung ist vorgesehen, dass die ersten elektrisch leitfähigen Drähte und/oder die zweiten elektrisch leitfähigen Drähte
i) einen Querschnitt mit einer Längsdimension von weniger als 50 nm, bevorzugt von weniger als 20 nm, insbesondere im Bereich 1 nm bis 10 nm aufweisen und/oder
ii) eine Länge von weniger als 50 nm, bevorzugt von weniger als 30 nm, insbesondere von 5 nm bis 20 nm aufweisen. Dadurch lassen sich besonders gut elektromagnetische Nahfelder erzeugen.

In einer vorteilhaften Weiterbildung ist vorgesehen, dass die Qubits ein-, zwei- oder dreidimensional angeordnet sind. Dadurch lassen sich besonders gut zahlreiche Qubits miteinander verschränken und dennoch unabhängig voneinander adressieren.

In einer vorteilhaften Weiterbildung ist vorgesehen, dass die elektrisch leitfähigen Strukturen eindimensional, zweidimensional oder dreidimensional angeordnet sind, wobei bevorzugt zwei oder mehr Ebenen bestehen, in denen elektrisch leitfähige Drähte, insbesondere parallel zueinander, angeordnet, wobei die elektrisch leitfähigen Strukturen verschiedener Ebenen unterschiedlich angeordnet sind, wobei zwischen zwei Ebenen vorzugsweise ein elektrischer Isolator angeordnet ist. Dadurch können die Qubits leicht adressiert und wieder ausgelesen werden. Die elektrisch leitfähigen Strukturen unterschiedlicher Ebenen sind schräg zueinander, vorzugsweise orthogonal zueinander angeordnet, weil sich dann elektromagnetische Felder mit elliptischer bzw. zirkularer Polarisation erzeugen lassen, wodurch sich Qutrits (double quantum transitions, vgl. den Artikel "Room temperature entanglement between distant single spins in diamond" von F. Dolde et al., Nature Physics, 9, 139-143 (2013)) erzeugen lassen.

In einer bevorzugten Ausgestaltung sind die Qubits Farbzentren, wobei die Mittel zur Erzeugung der elektromagnetischen Felder und der elektromagnetischen Gegenfelder elektrisch leitfähige Strukturen umfassen, die eine kleinere Dimension besitzen als der Abstand benachbarter Qubits. Dadurch lassen sich die Qubits besonders einfach addressieren.

Weiterhin wird selbständiger Schutz beansprucht für das erfindungsgemäße Verfahren zur Herstellung der erfindungsgemäßen Vorrichtung, das sich dadurch auszeichnet, dass zwei oder mehrere Qubits in einem Umgebungsmaterial erzeugt werden und auf dem Umgebungsmaterial erste elektrisch leitfähige Strukturen angeordnet werden.

In einer vorteilhaften Weiterbildung ist vorgesehen, dass zusätzlich zumindest einer der nachfolgenden Schritte durchgeführt wird:
- Durchführung eines ersten Temperierungsschrittes nach der Dotierung,
- Durchführung eines zweiten Temperierungsschrittes nach der Erzeugung der Qubits,
- Aufbringung von zweiten elektrisch leitfähigen Strukturen zum Auslesen der Qubits. Genauere Angaben zur Erzeugung der Qubits können der DE 10 2019 117 423.6 entnommen werden.

Die elektrisch leitfähigen Strukturen, wie Leitungen, Drähte und Metallisierungen, können mit verschiedenen Verfahren hergestellt werden. Zum einen ist ein Drucken möglich. Dann können sie durch Masken hindurch aufgebracht werden. Außerdem können Drähte auch direkt geschrieben werden, beispielsweise mit einer AFM-Spitze, wie es in dem Artikel "Atomic force microscope integrated with a scanning electron microscope for correlative nanofabrication and microscopy" von I.W. Rangelow et al., J. Vac. Sci. Technol. B 36 (6), Nov/Dec 2018 beschrieben ist.

Die Erzeugung der Qubits kann in einer bevorzugten Ausgestaltung die Implantation von Fremdatomen umfassen, die entsprechende dem in der Veröffentlichung "Nanoscale Engineering and Optical Addressing of Single Spins in Diamond", S. Pezzagna et al., small 2010, 6, No. 19, 2117-2121 beschrieben Verfahren mittels einer AFM-Spitze erfolgt, weil dadurch eine sehr genaue Positionierung der Qubits ermöglicht wird.

In einer bevorzugten Ausgestaltung werden als Qubits Farbzentren erzeugt und die elektrisch leitfähigen Strukturen werden so erzeugt, dass sie eine kleinere Dimension besitzen als der Abstand benachbarter Qubits. Dadurch lassen sich die Qubits besonders einfach addressieren.

Die Merkmale und weitere Vorteile der vorliegenden Erfindung werden im Folgenden anhand der Beschreibung bevorzugter Ausführungsbeispiele im Zusammenhang mit den Figuren deutlich. Dabei zeigen rein schematisch:
- Fig. 1: die erfindungsgemäße Vorrichtung in einer ersten bevorzugten Ausgestaltung in einer Ansicht von oben,
- Fig. 2: die erfindungsgemäße Vorrichtung nach Fig. 1 in einer Schnittansicht von der Seite,
- Fig. 3: die erfindungsgemäße Vorrichtung in einer ersten bevorzugten Ausgestaltung in einer Ansicht von oben und
- Fig. 4: die erfindungsgemäße Vorrichtung nach Fig. 3 in einer Schnittansicht von der Seite.

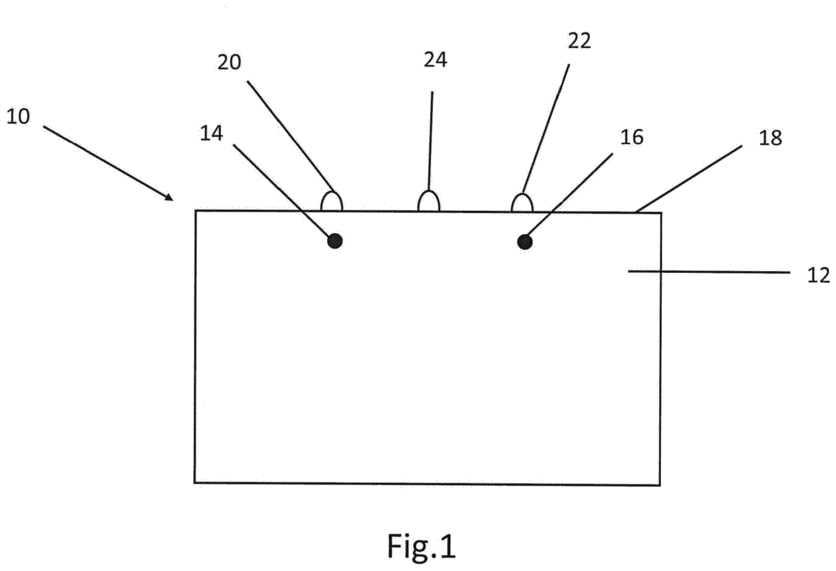

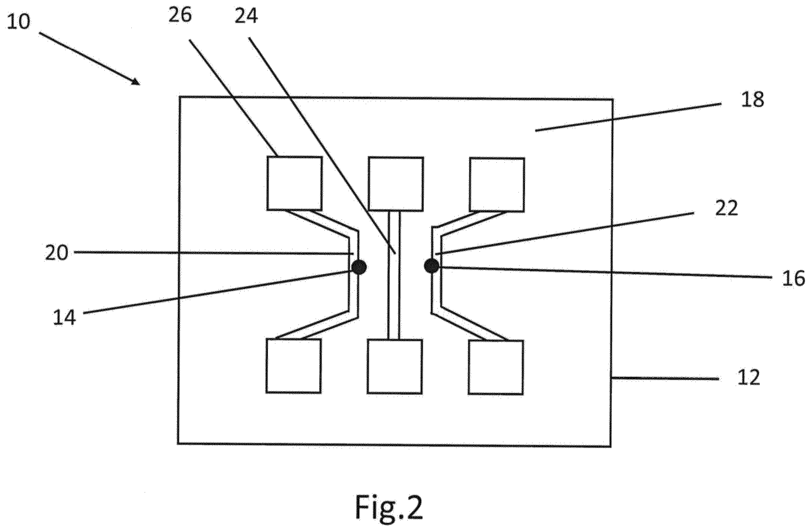

In den Fig. 1 und 2 ist eine erste bevorzugte Ausführungsform der erfindungsgemäßen Vorrichtung 10 näher dargestellt.

Es ist zu erkennen, dass die Vorrichtung 10 ein Diamant-Bulk-Material 12 aufweist, in dem zwei Qubits 14, 16 in einer Tiefe von ca. 10 nm unterhalb der Oberfläche 18 des Diamantmaterials 12 angeordnet sind.

Direkt oberhalb der beiden Qubits 14, 16 sind erste elektrisch leitfähige Drähte 20, 22 aus ITO (Indium-Tin-Oxide) angeordnet. Außerdem besteht ein zweiter elektrisch leitfähiger Draht 24, der aus Wolfram gebildet ist. Zur Kontaktierung weisen diese Drähte 20, 22, 24 jeweils entsprechende Kontaktflächen 26 auf, an die jeweils elektrische Anschlüsse (nicht gezeigt) angebondet werden können.

Die beiden ersten Drähte 20, 22, die der Adressierung und dem Auslesen der beiden Qubits 14, 16 dienen, weisen einen Abstand von etwa 20 nm bis 30 nm auf, was somit auch dem Abstand der beiden Qubits 14, 16 entspricht. Dadurch können sich diese Qubits 14, 16 leicht verschränken.

Der zweite Draht 24, der die Erdung für das Auslesen der Qubits 14, 16 bildet, ist mittig zwischen den beiden ersten Drähten 20, 22 angeordnet und weist somit einen Abstand von 10 nm bis 15 nm von diesen ersten Drähten 20, 22 auf. Alle Drähte 20, 22, 24 sind zueina n-der planparallel auf der Oberfläche 18 angeordnet. Sie weisen im geraden Bereich (vgl. Fig. 2) zwischen den Kontaktfläche 26 eine Länge von 5 nm bis 30 nm, bevorzugt 20 nm auf und eine Höhe und Breite im Bereich 1 nm bis 10 nm, bevorzugt von 5 nm.

Die Vorrichtung 10 funktioniert nun so, dass eine zeitgleiche Formatierung der Qubits 14, 16 durch einen geeigneten LASER-Puls durch die Oberfläche 18 gegeben wird, der durch die transparenten Drähte 20, 22 aus ITO ohne weiteres die Qubits 14, 16 erreicht. Dabei findet durch den Laser-Puls eine Spinpolarisation statt und alle Qubits 14, 16 gehen in den Grundzustand über. Dadurch hat man einen definierten und bekannten Ausgangszustand (Formatierung).

Alternativ könnten die Drähte 20, 22 beispielsweise auch aus Silber oder Gold gebildet sein, wobei dann aufgrund der sehr schmalen Dimensionierung der Drähte 20, 22 eine Beugung des LASER-Pulses um diese Drähte 20, 22 stattfindet, so dass auch dann der LASER-Puls die Qubits 14, 16 zur Formatierung erreicht.

Anschließend können die Qubits 14, 16 einzeln oder gemeinsam adressiert werden. Hierzu werden die Kontakte 26 der jeweiligen Drähte 20, 22 mit einem geeigneten hochfrequenten Strom beaufschlagt, der zur Adressierung der Kern-Spins der Qubits 14, 16 im Kilohertzbereich liegt. Durch den in den Drähten 20, 22 fließenden Strom wird jeweils ein Magnetfeld induziert, das auf den jeweiligen Qubit 14, 16 einwirkt.

Dabei bildet sich in unmittelbarer Umgebung der Drähte 20, 22 ein magnetisches Nahfeld aus, das aufgrund der Laplace-Gleichungen im Bereich der jeweils benachbart angeordneten Qubits 14, 16 überhöht ausgebildet ist und damit besonders gut auf die Kern-Spins dieser Qubits 14, 16 einwirkt.

Jedem Qubit 14, 16 wird so das passende magnetische Nahfeld aufgespeist, wodurch es adressiert wird. Zugleich wird dem jeweils anderen Qubit 16, 14 ein magnetisches Gegenfeld aufgespeist, das am Ort des jeweils anderen Qubits 16, 14 die magnetischen Feldko m-ponenten der zur Adressierung der Qubits 14, 16 verwendeten magnetischen Nahfelder so kompensiert, so dass kein Crosstalk stattfinden kann.

Dadurch können sowohl beide Qubits 14, 16 zugleich unterschiedlich oder auch identisch adressiert werden, als auch eine Adressierung ausschließlich eines einzelnen Qubits 14, 16 unabhängig von der Adressierung des anderen Qubits 16, 14 stattfinden.

Zum Auslesen der Qubits 14, 16 könnte beispielsweise wiederum eine geeignete einheitliche LASER-Bestrahlung stattfinden, wodurch in beiden Qubits 14, 16 Photoelektronen erzeugt werden, die dann über die jeweils zugeordneten ersten Drähte 20, 22 abgeschöpft und gemessen werden, wobei der zweite Draht 24 als Erdung dient. Dazu bestehen Umschalter, so dass die Drähte 20, 22 einmal zur Formatierung (also Stromzuführung) und einmal zum Auslesen (also Strommessen) verwendet werden können.

Alternativ könnten auch jedem Qubit 14, 16 gesondert geeignete LASER-Pulse durch geeignete Beleuchtungsmittel zugespeist werden, so dass die Qubits 14, 16 einzeln auslesbar sind.

Die Herstellung der Vorrichtung 10 könnte beispielsweise folgendermaßen erfolgen: Es wird eine Herstellung der Qubits 14, 16 unter Dotierung des Diamanten 12 mit anschließenden ersten und zweiten Temperierungsschritten entsprechend der DE 10 2019 117 423.6 vorgenommen, wobei die Schritte der Kontaktierung mit dem zweiten Draht 24 und der Maskierung sowie Kontaktierung mit den ersten Drähten 20, 22 in dieses Herstellungsverfahren geeignet integriert werden.

Genauer gesagt, wird ein Diamant 12 mit Schwefel oder einem anderen geeigneten Dotanden dotiert und einem ersten Temperierungsschritt bei etwa 1000°C unterzogen. Anschließend wird der zweite Draht 24 aus Wolfram zusammen mit den jeweiligen Kontaktflächen 26 beispielsweise mittels einer wieder entfernbaren Maske auf der Oberfläche 18 des Diamanten 12 aufgedampft.

Danach wird eine Kontaktmaske (in Fig. 1 der Übersichtlichkeit halber nicht gezeigt) aus Glas oder Siliziumkarbid auf der mit dem zweiten Draht 24 versehenen Oberfläche 18 des Diamanten 12 angeordnet, die zwei Öffnungen besitzt, die die Form der ersten Drähte 20, 22 aufweisen, und die im gewünschten Abstand von dem zweiten Draht 24 angeordnet sind.

Entsprechende Maskenherstellungsverfahren sind dem Fachmann geläufig, so dass hierauf nicht näher eingegangen werden muss.

Durch diese Maske erfolgt eine Implantation von Stickstoff, um die Qubits 14, 16 zu erzeugen. Dadurch wird auch die Position der Qubits 14, 16 unter den später gebildeten ersten Drähten 20, 22 exakt vorgegeben.

Nach einem zweiten Temperierungsschritt bei etwa 800°C werden die ersten Drähte 20, 22 zusammen mit den jeweiligen Kontaktflächen 26 aus ITO durch die Maske aufgedampft und so die Vorrichtung 10 fertig gestellt.

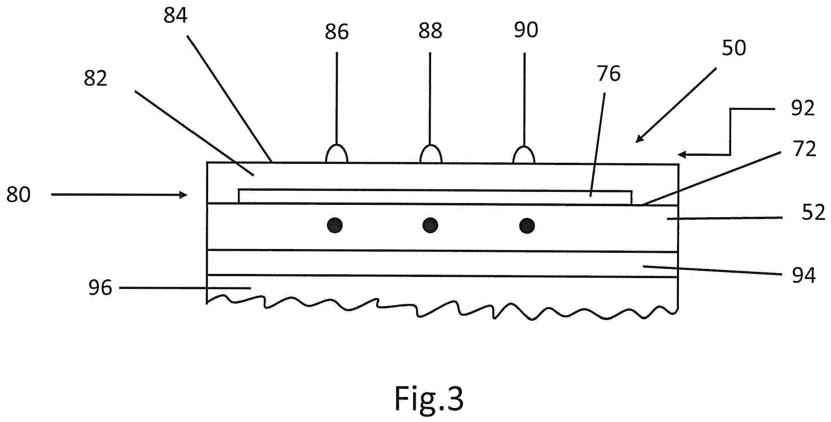

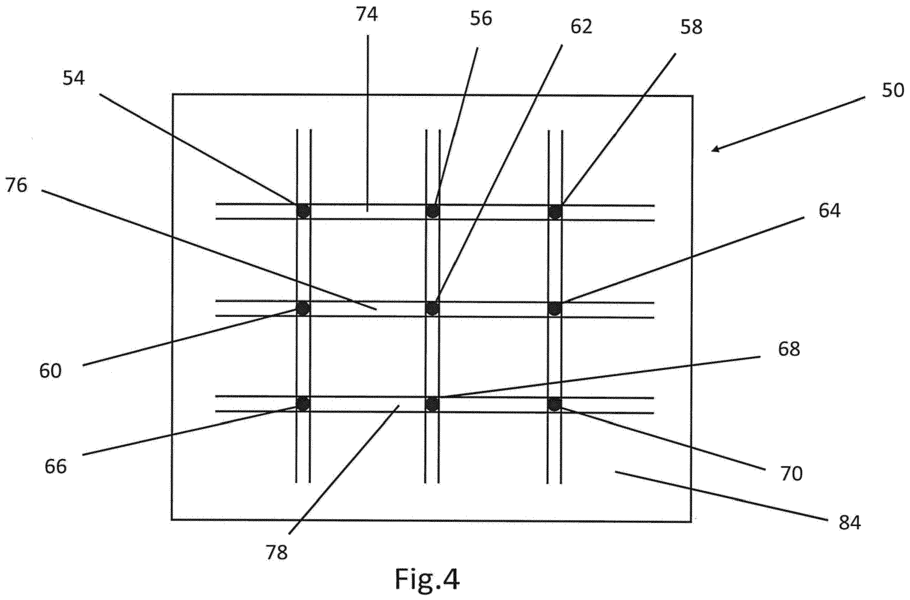

In den Fig. 3 und 4 ist eine zweite bevorzugte Ausführungsform der erfindungsgemäßen Vorrichtung 50 näher dargestellt.

Aus den Fig. 3 und 4 ist zu erkennen, dass die Vorrichtung 50 ein Diamant-Schicht-Material 52 aufweist, in dem neun Qubits 54, 56, 58, 60, 62, 64, 66, 68, 70 in einer Tiefe von ca. 10 nm unterhalb der Oberfläche 72 des Diamantmaterials 52 angeordnet sind.

Direkt oberhalb der neun Qubits 54, 56, 58, 60, 62, 64, 66, 68, 70 sind drei erste elektrisch leitfähige Drähte 74, 76, 78 aus ITO in einer ersten Ebene 80 angeordnet. Diese ersten Drähte 74, 76, 78 sind mit einer Isolatorschicht 82 überdeckt, die beispielsweise aus einem Oxid, insbesondere SiO2 gebildet sein kann. Auf der Oberfläche 84 der Isolatorschicht 82 sind drei weitere erste elektrisch leitfähige Drähte 86, 88, 90 in einer zweiten Ebene 92 angeordnet.

Die Drähte 74, 76, 78 in der ersten Ebene 80 sind planparallel zueinander ausgerichtet und die Drähte 86, 88, 90 in der zweiten Ebene 92 sind planparallel zueinander ausgerichtet. Die Drähte 74, 76, 78 der ersten Ebene 80 sind orthogonal zu den Drähten 86, 88, 90 der zweiten Ebene 92 ausgerichtet und alle Drähte sind voneinander elektrisch isoliert. Entsprechende Kontaktflächen wurden hier zur Vereinfachung der Darstellung nicht gezeigt. Auch diese ersten elektrisch leitfähigen Drähte 74, 76, 78, 86, 88, 90 weisen eine Höhe und Breite im Bereich 1 nm bis 10 nm, bevorzugt von 5 nm auf. Die Länge der geraden Abschnitte der Drähte 74, 76, 78, 86, 88, 90 ragt jeweils etwa 5 nm bis 10 nm über die äußeren Qubits 54, 56, 58, 60, 64, 66, 68, 70 hinaus.

Diese ersten elektrisch leitfähigen Drähte 74, 76, 78, 86, 88, 90 dienen wiederum der Adressierung und dem Auslesen der Qubits 54, 56, 58, 60, 62, 64, 66, 68, 70 und weisen einen Abstand von etwa 20 nm bis 30 nm in der jeweiligen Ebene 80, 92 auf, was somit auch dem Abstand der direkt unter den virtuellen Schnittpunkten der Drähte 74, 76, 78, 86, 88, 90 (vgl. Fig. 4) angeordneten Qubits 54, 56, 58, 60, 62, 64, 66, 68, 70 entspricht. Durch den Abstand von 20nm bis 30 nm können sich die Qubits 54, 56, 58, 60, 62, 64, 66, 68, 70 leicht verschränken.

Anstelle ein oder mehrerer zweiter elektrisch leitfähiger Drähte, wie bei der Vorrichtung 10 nach Fig. 1 und 2, besteht hier ein gemeinsamer Rückseitenkontakt 94, beispielsweise aus Wolfram, der sich zwischen der Diamantschicht 52 und einem Substrat 96 befindet. Dieser Rückseitenkontakt 94 dient als gemeinsame Erdung für das Auslesen der einzelnen Qubits 54, 56, 58, 60, 62, 64, 66, 68, 70.

Die Vorrichtung 50 funktioniert nun so, dass eine zeitgleiche Formatierung der Qubits 54, 56, 58, 60, 62, 64, 66, 68, 70 durch einen geeigneten LASER-Puls durch die Oberfläche 84 gegeben wird, der durch die transparenten Drähte 74, 76, 78, 86, 88, 90 aus ITO ohne weiteres die Qubits 14, 16 erreicht.

Die Adressierung der einzelnen Qubits 54, 56, 58, 60, 62, 64, 66, 68, 70 kann nun dadurch erfolgen, dass jedem Qubit 54, 56, 58, 60, 62, 64, 66, 68, 70 jeweils zwei erste Drähte 74, 76, 78, 86, 88, 90 zugeordnet sind, wodurch durch unterschiedliche geeignete Signale auf den sich jeweils kreuzenden ersten Drähten 74, 76, 78, 86, 88, 90 jeder einzelne Qubit 54, 56, 58, 60, 62, 64, 66, 68, 70 durch die sich individuell ausbildenden magnetischen Nahfelder individuell adressiert werden kann. Genauer gesagt befinden sich die Qubits 54, 56, 58, 60, 62, 64, 66, 68, 70 in Bezug auf eine Projektion auf die Ebenen 80, 92 in der Nähe von Kreuzungspunkten von ersten Drähten 74, 76, 78, 86, 88, 90, so dass sich in den sich kreuzenden Drähten 74, 76, 78, 86, 88, 90 angelegte magnetische Hochfrequenzfelder sich überlagern, so dass sich für jedes Qubit 54, 56, 58, 60, 62, 64, 66, 68, 70 individuelle magnetische Nahfelder einstellen. Durch individuell angepasste magnetische Gegenfelder in diesen individuellen Nahfeldern werden dabei die Einflüsse der magnetischen Nahfelder der jeweils übrigen Qubits 54, 56, 58, 60, 62, 64, 66, 68, 70 ausgeschaltet bzw. ausreichend reduziert.

Durch die sich kreuzenden Drähte 74, 76, 78, 86, 88, 90 können so elliptisch oder zirkular polarisierte magnetische Nahfelder für jeden Qubit 54, 56, 58, 60, 62, 64, 66, 68, 70 erzeugt werden, so dass Qutrit-Zustände herstellbar sind.

Zum Zwecke des Auslesens der Qubits 54, 56, 58, 60, 62, 64, 66, 68, 70 wird beispielsweise ein geeigneter LASER-Puls verwendet, wobei die ersten Drähte 74, 76, 78, 86, 88, 90 von einer Stromspeisung umgeschaltet werden auf eine Strommessung und der Rückseitenkontakt als Erdung für die erzeugten Photoelektronen dient. Durch die Kombination der einzelnen Messsignale der ersten Drähte 74, 76, 78, 86, 88, 90 kann jedem Qubit 54, 56, 58, 60, 62, 64, 66, 68, 70 sein spezielles Messsignal zugeordnet werden.

Die Herstellung der Vorrichtung 50 könnte beispielsweise folgendermaßen erfolgen: Es wird eine Herstellung der Qubits 54, 56, 58, 60, 62, 64, 66, 68, 70 unter Dotierung des Diamant-Schichtmaterials 52 mit anschließenden ersten und zweiten Temperierungsschritten entsprechend der DE 10 2019 117 423.6 vorgenommen, wobei die Schritte der Kontaktierung mit dem Rückseitenkontakt 94 und der Kontaktierung mit den ersten Drähten 74, 76, 78, 86, 88, 90 in dieses Herstellungsverfahren geeignet integriert werden.

Genauer gesagt, wird hier auf einem geeigneten Substratmaterial 96 ein Rückseitenkontakt 94 aus Wolfram durch Abscheiden, beispielsweise Aufsputtern, erzeugt und darauf eine Diamant-Schicht 52 beispielsweise durch Gasphasenabscheidung angeordnet. Diese Diamantschicht 52 wird mit Schwefel oder einem anderen Dotanden gemäße der DE 10 2019 117 423.6 dotiert und einem ersten Temperierungsschritt bei etwa 1000°C unterzogen.

Anschließend wird Stickstoff zur Erzeugung der Qubits 54, 56, 58, 60, 62, 64, 66, 68, 70 implantiert, wobei zur genauen Positionierung der Qubits 54, 56, 58, 60, 62, 64, 66, 68, 70 der Stickstoff mit einer AFM-Spitze implantiert wird. Dieses Verfahren ist beispielsweise grundsätzlich in dem Artikel "Nanoscale Engineering and Optical Addressing of Single Spins in Diamond", S. Pezzagna et al., small 2010, 6, 19, 2117-2121 beschrieben. Zur Orientierung können Hilfsmarkierungen in Form von Graphit-Marken oder Metalldrähten außerhalb des mit den Qubits 54, 56, 58, 60, 62, 64, 66, 68, 70 zu versehenden Oberflächenbereichs angeordnet werden.

Nach einem zweiten Temperierungsschritt bei etwa 800°C werden die ersten Drähte 74, 76, 78 der Ebene 80, beispielsweise aus Silber, mit Hilfe einer AFM-Spitze auf der Oberfläche 72 des Diamantmaterials 52 gezeichnet und entsprechende Kontaktflächen (nicht gezeigt) erzeugt. Anschließend wird eine geeignete elektrische Isolatorschicht 82, wie beispielsweise aus SiO2, auf der Oberfläche 72 des Diamantmaterials 52 angeordnet, wodurch die ersten Drähte 74, 76, 78 überdeckt werden. Schließlich werden die ersten Drähte 86, 88, 90 der zweiten Ebene 92 auf der Oberfläche 84 der Isolatrschicht 82 ebenfalls durch Zeichnen mit der AFM-Spitze angeordnet.

Das Drahtzeichnen mit der AFM-Spitze kann dabei entsprechend dem in der Veröffentlichung "Atomic force microscope integrated with a scanning electron microscope for correlative nanofabrication and microscopy" von I.W. Rangelow et al., J. Vac. Sci. Technol. B 36 (6), Nov/Dec 2018 grundsätzlich beschriebenen Verfahren erfolgen. Außerdem können wiederum Marker bzw. Hilfsdrähte zur Orientierung verwendet werden.

Alternativ zum Drahtzeichnen mit einer AFM-Spitze können auch wiederum maskenbasierte Verfahren zur Erzeugung der ersten Drähte 74, 76, 78, 86, 88, 90 verwendet werden, wobei diese Masken bevorzugt jedes Mal abgetragen werden, um einen möglichst geringen Abstand zwischen den Drähten 74, 76, 78, 86, 88, 90 und den jeweils zugeordneten Qubits 54, 56, 58, 60, 62, 64, 66, 68, 70 sicherzustellen.

Aus der vorstehenden Darstellung ist deutlich geworden, dass mit der vorliegenden Erfindung eine Adressierung von Qubits 14, 16, 54, 56, 58, 60, 62, 64, 66, 68, 70 auf einfache Art und Weise ermöglicht wird, ohne dass die Gefahr des Übersprechens zwischen verschiedenen Qubits 14, 16, 54, 56, 58, 60, 62, 64, 66, 68, 70 besteht. Die Adressierung kann dabei sowohl einzeln als auch gemeinsam für unterschiedliche Qubits 14, 16, 54, 56, 58, 60, 62, 64, 66, 68, 70 erfolgen. Zusätzlich ist auch ein leichtes Auslesen der Qubits 14, 16, 54, 56, 58, 60, 62, 64, 66, 68, 70 möglich.

### Bezugszeichenliste

- 10: erste bevorzugte Ausgestaltung der erfindungsgemäßen Vorrichtung
- 12: Diamant-Bulk-Material
- 14, 16: Qubits
- 18: Oberfläche des Diamantmaterials 12
- 20, 22: erste elektrisch leitfähige Drähte aus ITO (Indium-Tin-Oxide)
- 24: zweiter elektrisch leitfähiger Draht aus Wolfram
- 26: Kontaktflächen der Drähte 20, 22, 24
- 50: zweite bevorzugte Ausgestaltung der erfindungsgemäßen Vorrichtung
- 52: Diamant-Schicht-Material
- 54, 56, 58: Qubits
- 60, 62, 64: Qubits
- 66, 68, 70: Qubits
- 72: Oberfläche des Diamantmaterials 52
- 74, 76, 78: erste elektrisch leitfähige Drähte aus ITO (Indium-Tin-Oxide)
- 80: erste Ebene, in der die Drähte 74, 76, 78 angeordnet sind
- 82: Isolatorschicht
- 84: Oberfläche der Isolatorschicht 82
- 86, 88, 90: erste elektrisch leitfähige Drähte aus ITO (Indium-Tin-Oxide)
- 92: zweiten Ebene, in der die Drähte 86, 88, 90 angeordnet sind
- 94: Rückseitenkontakt aus Wolfram
- 96: Substrat

## Patentansprüche

1. Verfahren zur Adressierung zumindest eines Qubits (54, 56, 58, 60, 62, 64, 66, 68, 70) aus einer Menge von zwei oder mehr Qubits (54, 56, 58, 60, 62, 64, 66, 68, 70), **dadurch gekennzeichnet, dass** das zu adressierende Qubit (54, 56, 58, 60, 62, 64, 66, 68, 70) einem elektromagnetischen Feld in Form eines magnetischen Nahfeldes ausgesetzt wird, um den Zustand des Qubits (54, 56, 58, 60, 62, 64, 66, 68, 70) zu ändern, während zumindest ein anderes Qubit der Menge Qubits (54, 56, 58, 60, 62, 64, 66, 68, 70) einem elektromagnetischen Gegenfeld in Form eines magnetischen Nahfeldes so ausgesetzt wird, dass das elektromagnetische Feld keine Wirkung auf das andere Qubit (54, 56, 58, 60, 62, 64, 66, 68, 70) hat oder dass das elektromagnetische Feld eine andere Wirkung auf das andere Qubit (54, 56, 58, 60, 62, 64, 66, 68, 70) hat als auf das zu adressierende Qubit (54, 56, 58, 60, 62, 64, 66, 68, 70), wobei in unterschiedlichen Ebenen (80, 92) elektrisch leitfähige Strukturen (74, 76, 78, 86, 88, 90) angeordnet sind, wobei die elektrisch leitfähigen Strukturen (74, 76, 78, 86, 88, 90) unterschiedlicher Ebenen (80, 92) schräg zueinander angeordnet sind, wobei sich die Qubits (54, 56, 58, 60, 62, 64, 66, 68, 70) in Bezug auf eine Projektion auf die Ebenen (80, 92) in der Nähe von Kreuzungspunkten von ersten Drähten (74, 76, 78, 86, 88, 90) befinden, wobei die Qubits (54, 56, 58, 60, 62, 64, 66, 68, 70) in einer Diamantschicht (52) als Umgebungsmaterial vorliegen, wobei das Umgebungsmaterial mit Schwefel, Phosphor oder Sauerstoff dotiert wurde, wobei als Qubits (54, 56, 58, 60, 62, 64, 66, 68, 70) NV-Zentren in Diamant (52) verwendet werden.

2. Verfahren nach Anspruch 1, **dadurch gekennzeichnet, dass** die magnetischen Nahfelder eine Frequenz im Mikrowellenbereich und/oder oder Kilohertzbereich aufweisen und/oder
dass magnetische Nahfelder mit elliptischer oder zirkularer Polarisation erzeugt werden, um Qutrits zu erzeugen.

3. Verfahren nach Anspruch 1 oder 2, **dass** die elektromagnetischen Felder und elektromagnetischen Gegenfelder durch elektromagnetische Quellen (74, 76, 78, 86, 88, 90), bevorzugt elektrisch leitfähige Strukturen, insbesondere Leitungen, Metallisierungen oder Drähte (74, 76, 78, 86, 88, 90) bereitgestellt werden, wobei die elektrisch leitfähigen Strukturen (74, 76, 78, 86, 88, 90) eine kleinere Dimension besitzen als der Abstand benachbarter Qubits (54, 56, 58, 60, 62, 64, 66, 68, 70).

4. Verfahren nach einem der vorherigen Ansprüche, **dadurch gekennzeichnet, dass** die Qubits (54, 56, 58, 60, 62, 64, 66, 68, 70) in einem transparenten Material (52) bestehen, so dass eine Formatierung der Qubits (54, 56, 58, 60, 62, 64, 66, 68, 70), bevorzugt eine gleichzeitige Formatierung mehrerer, insbesondere aller Qubits (54, 56, 58, 60, 62, 64, 66, 68, 70), mittels einer optischen Strahlung, vorzugsweise einer LASER-Strahlung, erfolgen kann.

5. Vorrichtung zur Adressierung zumindest eines Qubits (54, 56, 58, 60, 62, 64, 66, 68, 70) aus einer Menge von zwei oder mehr Qubits (54, 56, 58, 60, 62, 64, 66, 68, 70),
**dadurch gekennzeichnet, dass** die Vorrichtung Mittel (74, 76, 78, 86, 88, 90) zur Erzeugung eines elektromagnetischen Feldes in Form eines magnetischen Nahfeldes aufweist, die so ausgebildet sind, dass das zu adressierende Qubit (54, 56, 58, 60, 62, 64, 66, 68, 70) zur Änderung des Zustands des Qubits (54, 56, 58, 60, 62, 64, 66, 68, 70) dem elektromagnetischen Feld ausgesetzt werden kann, und dass die Vorrichtung Mittel (74, 76, 78, 86, 88, 90) zur Erzeugung zumindest eines elektromagnetischen Gegenfelds in Form eines magnetischen Nahfeldes aufweist, die so ausgebildet sind, dass zumindest ein anderes Qubit der Menge Qubits (54, 56, 58, 60, 62, 64, 66, 68, 70) dem elektromagnetischen Gegenfeld so ausgesetzt werden kann, dass das elektromagnetische Feld keine Wirkung auf das andere Qubit (54, 56, 58, 60, 62, 64, 66, 68, 70) hat oder dass das elektromagnetische Feld eine andere Wirkung auf das andere Qubit (54, 56, 58, 60, 62, 64, 66, 68, 70) hat als auf das zu adressierende Qubit (54, 56, 58, 60, 62, 64, 66, 68, 70), wobei in unterschiedlichen Ebenen (80, 92) elektrisch leitfähige Strukturen (74, 76, 78, 86, 88, 90) angeordnet sind, wobei die elektrisch leitfähigen Strukturen (74, 76, 78, 86, 88, 90) unterschiedlicher Ebenen (80, 92) schräg zueinander angeordnet sind, wobei sich die Qubits (54, 56, 58, 60, 62, 64, 66, 68, 70) in Bezug auf eine Projektion auf die Ebenen (80, 92) in der Nähe von Kreuzungspunkten von ersten Drähten (74, 76, 78, 86, 88, 90) befinden, wobei die Qubits (54, 56, 58, 60, 62, 64, 66, 68, 70) in einer Diamantschicht (52) als Umgebungsmaterial vorliegen, wobei das Umgebungsmaterial mit Schwefel, Phosphor oder Sauerstoff dotiert ist, wobei die Qubits (54, 56, 58, 60, 62, 64, 66, 68, 70) durch NV-Zentren in Diamant (52) gebildet sind.

6. Vorrichtung nach Anspruch 5, **dadurch gekennzeichnet, dass** die Vorrichtung angepasst ist, das Verfahren nach einem der Ansprüche 1 bis 4 durchzuführen.

7. Vorrichtung nach Anspruch 5 oder 6, **dadurch gekennzeichnet, dass** die Vorrichtung elektromagnetische Quellen (74, 76, 78, 86, 88, 90), bevorzugt erste elektrisch leitfähige Strukturen, insbesondere Leitungen, Drähte (74, 76, 78, 86, 88, 90) oder Metallisierungen, zur Erzeugung der elektromagnetischen Felder und der elektromagnetischen Gegenfelder aufweist, wobei jedem Qubit (54, 56, 58, 60, 62, 64, 66, 68, 70) zumindest eine elektromagnetische Quelle zugeordnet ist.

8. Vorrichtung nach Anspruch 7, **dadurch gekennzeichnet, dass** mehrere elektromagnetische Quellen (74, 76, 78, 86, 88, 90) in einer Ebene angeordnet sind, wobei die Qubits (54, 56, 58, 60, 62, 64, 66, 68, 70) einen Abstand senkrecht zu dieser Ebene von der jeweils zugeordneten elektromagnetischen Quelle von höchstens 30 nm, bevorzugt von höchstens 20 nm, insbesondere im Bereich 0 nm bis 10 nm aufweisen und/oder
wobei die Qubits (54, 56, 58, 60, 62, 64, 66, 68, 70) projiziert auf diese Ebene einen Abstand von der jeweils zugeordneten elektromagnetischen Quelle (74, 76, 78, 86, 88, 90) von höchstens 20 nm, bevorzugt von höchstens 10 nm, insbesondere im Bereich 0 nm bis 5 nm aufweisen.

9. Vorrichtung nach einem der Ansprüche 7 oder 8, **dadurch gekennzeichnet, dass** zumindest eine erste elektrisch leitfähige Struktur (74, 76, 78, 86, 88, 90) wahlweise mit einer elektromagnetischen Anregung und einer Photoelektronenerfassung verbindbar ist.

10. Vorrichtung nach einem der Ansprüche 7 bis 9, **dadurch gekennzeichnet, dass** zumindest eine zweite elektrisch leitfähige Struktur (94), bevorzugt ein zweiter elektrisch leitfähiger Draht, eine Leitung oder eine Metallisierung oder eine Elektrode (94) besteht, die die Erdung für das Auslesen der Qubits (54, 56, 58, 60, 62, 64, 66, 68, 70) bildet, wobei die zweite elektrisch leitfähige Struktur bevorzugt benachbart zu einer ersten elektromagnetischen Quelle angeordnet ist, insbesondere in einem Abstand in einer Ebene von höchstens 40 nm, bevorzugt höchstens 30 nm, insbesondere in einem Bereich von 10 nm bis 20 nm.

11. Vorrichtung nach einem der Ansprüche 7 bis 10, **dadurch gekennzeichnet, dass** die ersten elektrisch leitfähigen Strukturen (74, 76, 78, 86, 88, 90) und/oder die zweiten elektrisch leitfähigen Strukturen
i) einen Querschnitt mit einer Längsdimension von weniger als 50 nm, bevorzugt von weniger als 20 nm, insbesondere im Bereich 1 nm bis 10 nm aufweisen und/oder
ii) eine Länge von weniger als 50 nm, bevorzugt von weniger als 30 nm, insbesondere von 5 nm bis 20 nm aufweisen.

12. Vorrichtung nach einem der Ansprüche 5 bis 11, **dadurch gekennzeichnet,**
**dass** die Qubits (54, 56, 58, 60, 62, 64, 66, 68, 70) ein-, zwei- oder dreidimensional angeordnet sind und/oder
**dass** die elektrisch leitfähigen Strukturen (74, 76, 78, 86, 88, 90) ein-, zwei- oder dreidimensional angeordnet sind, wobei bevorzugt zwei oder mehr Ebenen (80, 92) bestehen, in denen elektrisch leitfähige Strukturen (74, 76, 78, 86, 88, 90), insbesondere parallel zueinander, angeordnet sind, wobei die elektrisch leitfähigen Strukturen (74, 76, 78, 86, 88, 90) verschiedener Ebenen (80, 92) unterschiedlich angeordnet sind, wobei zwischen zwei Ebenen (80, 92) vorzugsweise ein elektrischer Isolator (82) angeordnet ist.

13. Verfahren zur Herstellung einer Vorrichtung nach einem der Ansprüche 5 bis 12,
**dadurch gekennzeichnet, dass** zwei oder mehrere Qubits (54, 56, 58, 60, 62, 64, 66, 68, 70) in einem Umgebungsmaterial erzeugt werden und auf dem Umgebungsmaterial erste elektrisch leitfähige Drähte (74, 76, 78, 86, 88, 90) angeordnet werden, wobei eine Diamantschicht (52) als das Umgebungsmaterial gewählt wird und das Umgebungsmaterial mit Schwefel, Phosphor oder Sauerstoff dotiert wird.

14. Verfahren nach Anspruch 13, **dadurch gekennzeichnet, dass** zusätzlich zumindest einer der nachfolgenden Schritte durchgeführt wird:
- Durchführung eines ersten Temperierungsschrittes nach der Dotierung,
- Durchführung eines zweiten Temperierungsschrittes nach der Erzeugung der Qubits (54, 56, 58, 60, 62, 64, 66, 68, 70),
- Aufbringung von zweiten elektrisch leitfähigen Drähten zum Auslesen der Qubits (54, 56, 58, 60, 62, 64, 66, 68, 70).

## Claims

1. Method for addressing at least one qubit (54, 56, 58, 60, 62, 64, 66, 68, 70) from a set of two or more qubits (54, 56, 58, 60, 62, 64, 66, 68, 70), **characterised in that** the qubit (54, 56, 58, 60, 62, 64, 66, 68, 70) to be addressed is exposed to an electromagnetic field in the form of a magnetic near field in order to change the state of the qubit (54, 56, 58, 60, 62, 64, 66, 68, 70) while at least one other qubit of the set of qubits (54, 56, 58, 60, 62, 64, 66, 68, 70) is exposed to an opposing electromagnetic field in the form of a magnetic near field in such a way that the electromagnetic field does not have an effect on the other qubit (54, 56, 58, 60, 62, 64, 66, 68, 70) or in such a way that the electromagnetic field has another effect on the other qubit (54, 56, 58, 60, 62, 64, 66, 68, 70) than on the qubit (54, 56, 58, 60, 62, 64, 66, 68, 70) to be addressed, wherein electrically conductive structures (74, 76, 78, 86, 88, 90) are arranged in different planes (80, 92), wherein the electrically conductive structures (74, 76, 78, 86, 88, 90) of different planes (80, 92) are arranged at an angle to one another, wherein the qubits (54, 56, 58, 60, 62, 64, 66, 68, 70) are located in the vicinity of crossing points of first wires (74, 76, 78, 86, 88, 90) with respect to a projection onto the planes (80, 92), wherein the qubits (54, 56, 58, 60, 62, 64, 66, 68, 70) are provided in a diamond layer (52) as surrounding material, wherein the surrounding material has been doped with sulphur, phosphorus or oxygen, wherein NV centres in diamond (52) are used as qubits (54, 56, 58, 60, 62, 64, 66, 68, 70).

2. Method according to claim 1, **characterised in that** the magnetic near fields have a frequency in the microwave and/or kilohertz range and/or the magnetic near fields are generated with elliptical or circular polarisation in order to generate qutrits.

3. Method according to claim 1 or 2, **in that** the electromagnetic fields and opposing electromagnetic fields are provided by electromagnetic sources (74, 76, 78, 86, 88, 90), preferably electrically conductive structures, in particular lines, metallisations or wires (74, 76, 78, 86, 88, 90), wherein the electrically conductive structures (74, 76, 78, 86, 88, 90) have a smaller dimension than the distance between adjacent qubits (54, 56, 58, 60, 62, 64, 66, 68, 70).

4. Method according to any one of the preceding claims, **characterised in that** the qubits (54, 56, 58, 60, 62, 64, 66, 68, 70) consist in a transparent material (52), such that formatting of the qubits (54, 56, 58, 60, 62, 64, 66, 68, 70), preferably simultaneous formatting of a plurality of, in particular all qubits (54, 56, 58, 60, 62, 64, 66, 68, 70), can take place by means of an optical radiation, preferably a laser radiation.

5. Device for addressing at least one qubit (54, 56, 58, 60, 62, 64, 66, 68, 70) from a set of two or more qubits (54, 56, 58, 60, 62, 64, 66, 68, 70), **characterised in that** the device has means (74, 76, 78, 86, 88, 90) for generating an electromagnetic field in the form of a magnetic near field, which means are designed such that the qubit (54, 56, 58, 60, 62, 64, 66, 68, 70) to be addressed can be exposed to the electromagnetic field to change the state of the qubit (54, 56, 58, 60, 62, 64, 66, 68, 70), and **in that** the device has means (74, 76, 78, 86, 88, 90) for generating at least one opposing electromagnetic field in the form of a magnetic near field, which means are designed such that at least one other qubit of the set of qubits (54, 56, 58, 60, 62, 64, 66, 68, 70) can be exposed to the opposing electromagnetic field in such a way that the electromagnetic field does not have an effect on the other qubit (54, 56, 58, 60, 62, 64, 66, 68, 70) or in such a way that the electromagnetic field has another effect on the other qubit (54, 56, 58, 60, 62, 64, 66, 68, 70) than on the qubit (54, 56, 58, 60, 62, 64, 66, 68, 70) to be addressed, wherein electrically conductive structures (74, 76, 78, 86, 88, 90) are arranged in different planes (80, 92), wherein the electrically conductive structures (74, 76, 78, 86, 88, 90) of different planes (80, 92) are arranged at an angle to one another, wherein the qubits (54, 56, 58, 60, 62, 64, 66, 68, 70) are located in the vicinity of crossing points of first wires (74, 76, 78, 86, 88, 90) with respect to a projection onto the planes (80, 92), wherein the qubits (54, 56, 58, 60, 62, 64, 66, 68, 70) are provided in a diamond layer (52) as surrounding material, wherein the surrounding material is doped with sulphur, phosphorus or oxygen, wherein the qubits (54, 56, 58, 60, 62, 64, 66, 68, 70) are formed by NV centres in diamond (52).

6. Device according to claim 5, **characterised in that** the device is adapted to carry out the method according to any one of claims 1 to 4.

7. Device according to claim 5 or 6, **characterised in that** the device has electromagnetic sources (74, 76, 78, 86, 88, 90), preferably first electrically conductive structures, in particular lines, wires (74, 76, 78, 86, 88, 90) or metallisations, for generating the electromagnetic fields and the opposing electromagnetic fields, wherein each qubit (54, 56, 58, 60, 62, 64, 66, 68, 70) is associated with at least one electromagnetic source.

8. Device according to claim 7, **characterised in that** a plurality of electromagnetic sources (74, 76, 78, 86, 88, 90) are arranged in one plane,
wherein the qubits (54, 56, 58, 60, 62, 64, 66, 68, 70) have a distance perpendicular to this plane from the respective associated electromagnetic source of at most 30 nm, preferably of at most 20 nm, in particular in the range of 0 nm to 10 nm and/or
wherein the qubits (54, 56, 58, 60, 62, 64, 66, 68, 70) projected on this plane have a distance from the respective associated electromagnetic source (74, 76, 78, 86, 88, 90) of at most 20 nm, preferably of at most 10 nm, in particular in the range of 0 nm to 5 nm.

9. Device according to either one of claims 7 or 8, **characterised in that** at least one first electrically conductive structure (74, 76, 78, 86, 88, 90) can be selectively connected to an electromagnetic excitation and a photoelectron detection.

10. Device according to any one of claims 7 to 9, **characterised in that** there is at least one second electrically conductive structure (94), preferably a second electrically conductive wire, a line or a metallisation or an electrode (94) that forms the earthing for reading out the qubit (54, 56, 58, 60, 62, 64, 66, 68, 70), wherein the second electrically conductive structure is preferably arranged adjacent to a first electromagnetic source, in particular at a distance in a plane of at most 40 nm, preferably at most 30 nm, in particular in a range of 10 nm to 20 nm.

11. Device according to any one of claims 7 to 10, **characterised in that** the first electrically conductive structures (74, 76, 78, 86, 88, 90) and/or the second electrically conductive structures have
i) a cross-section with a longitudinal dimension of less than 50 nm, preferably less than 20 nm, in particular in the range of 1 nm to 10 nm and/or
ii) a length of less than 50 nm, preferably of less than 30 nm, in particular of 5 nm to 20 nm.

12. Device according to any one of claims 5 to 11, **characterised in that** the qubits (54, 56, 58, 60, 62, 64, 66, 68, 70) are arranged one-dimensionally, two-dimensionally or three-dimensionally and/or
the electrically conductive structures (74, 76, 78, 86, 88, 90) are arranged one-dimensionally, two-dimensionally or three-dimensionally, wherein there are preferably two or more planes (80, 92), in which electrically conductive structures (74, 76, 78, 86, 88, 90) are arranged, in particular parallel to one another, wherein the electrically conductive structures (74, 76, 78, 86, 88, 90) of different planes (80, 92) are arranged differently, wherein an electrical insulator (82) is preferably arranged between two planes (80, 92).

13. Method for producing a device according to any one of claims 5 to 12,
**characterised in that** two or more qubits (54, 56, 58, 60, 62, 64, 66, 68, 70) are generated in a surrounding material and first electrically conductive wires (74, 76, 78, 86, 88, 90) are arranged on the surrounding material, wherein a diamond layer (52) is selected as the surrounding material and the surrounding material is doped with sulphur, phosphorus or oxygen.

14. Method according to claim 13, **characterised in that** additionally at least one of the following steps is performed:
- performing a first tempering step after doping,
- performing a second tempering step after generating the qubits (54, 56, 58, 60, 62, 64, 66, 68, 70),
- applying second electrically conductive wires for reading out the qubits (54, 56, 58, 60, 62, 64, 66, 68, 70).

## Revendications

1. Procédé d'adressage d'au moins un qubit (54, 56, 58, 60, 62, 64, 66, 68, 70) issu d'une quantité de deux qubits ou plus (54, 56, 58, 60, 62, 64, 66, 68, 70),
**caractérisé en ce que** le qubit (54, 56, 58, 60, 62, 64, 66, 68, 70) à adresser est exposé à un champ électromagnétique sous la forme d'un champ proche magnétique pour modifier l'état du qubit (54, 56, 58, 60, 62, 64, 66, 68, 70), tandis qu'au moins un autre qubit de la quantité de qubits (54, 56, 58, 60, 62, 64, 66, 68, 70) est exposé à un contre-champ électromagnétique sous la forme d'un champ proche magnétique de telle sorte que le champ électromagnétique n'exerce aucune action sur l'autre qubit (54, 56, 58, 60, 62, 64, 66, 68, 70) ou que le champ électromagnétique exerce une action sur l'autre qubit (54, 56, 58, 60, 62, 64, 66, 68, 70) autre que sur le qubit (54, 56, 58, 60, 62, 64, 66, 68, 70) à adresser, dans lequel des structures électriquement conductrices (74, 76, 78, 86, 88, 90) sont disposées dans des plans (80, 92) différents, dans lequel les structures (74, 76, 78, 86, 66, 90) électriquement conductrices de différents plans (80, 92) sont disposées de manière oblique les unes par rapport aux autres, dans lequel les qubits (54, 56, 58, 60, 62, 64, 66, 68, 70) se trouvent par rapport à une projection sur les plans (80, 92) à proximité de points d'intersection de premiers fils (74, 76, 78, 86, 88, 90), dans lequel les qubits (54, 56, 58, 60, 62, 64, 66, 68, 70) sont présents en tant que matériau environnant dans une couche en diamant (52), dans lequel le matériau environnant est dopé au soufre, au phosphore ou à l'oxygène, dans lequel des centres NV en diamant (52) sont utilisés en tant que qubits (54, 56, 58, 60, 62, 64, 66, 68, 70).

2. Procédé selon la revendication 1, **caractérisé en ce que** les champs proches magnétiques présentent une fréquence dans la plage de micro-ondes et/ou dans la plage de kilohertz et/ou
**que** des champs proches magnétiques sont générés avec une polarisation elliptique ou circulaire pour générer des qutrits.

3. Procédé selon la revendication 1 ou 2, **caractérisé que** les champs électromagnétiques et les contre-champs électromagnétiques sont fournis par des sources électromagnétiques (74, 76, 78, 86, 88, 90), de manière préférée des structures électriquement conductrices, en particulier des câbles, des métallisations ou des fils (74, 76, 78, 86, 88, 90), dans lequel les structures électriquement conductrices (74, 76, 78, 86, 88, 90) possèdent une dimension inférieure à la distance de qubits (54, 56, 58, 60, 62, 64, 66, 68, 70) adjacents.

4. Procédé selon l'une quelconque des revendications précédentes, **caractérisé en ce que** les qubits (54, 56, 58, 60, 62, 64, 66, 68, 70) sont constitués d'un matériau transparent (52), de telle sorte qu'un formatage des qubits (54, 56, 58, 60, 62, 64, 66, 68, 70), de manière préférée un formatage simultané de plusieurs, en particulier de tous les qubits (54, 56, 58, 60, 62, 64, 66, 68, 70) peut être effectué au moyen d'un rayonnement optique, de préférence d'un rayonnement LASER.

5. Dispositif d'adressage d'au moins un qubit (54, 56, 58, 60, 62, 64, 66, 68, 70) issu d'une quantité de deux qubits ou plus (54, 56, 58, 60, 62, 64, 66, 68, 70),
**caractérisé en ce que** le dispositif présente des moyens (74, 76, 78, 86, 88, 90) destinés à générer un champ électromagnétique sous la forme d'un champ proche magnétique, qui sont réalisés de telle sorte que le qubit (54, 56, 58, 60, 62, 64, 66, 68, 70) à adresser peut être exposé au champ électromagnétique pour modifier l'état du qubit (54, 56, 58, 60, 62, 64, 66, 68, 70), et que le dispositif présente des moyens (74, 76, 78, 86, 88, 90) destinés à générer au moins un contre-champ électromagnétique sous la forme d'un champ proche magnétique, qui sont réalisés de telle sorte qu'au moins un autre qubit de la quantité de qubits (54, 56, 58, 60, 62, 64, 66, 68, 70) peut être exposé au contre-champ électromagnétique de telle sorte que le champ électromagnétique n'exerce aucune action sur l'autre qubit (54, 56, 58, 60, 62, 64, 66, 68, 70) ou que le champ électromagnétique exerce une action sur l'autre qubit (54, 56, 58, 60, 62, 64, 66, 68, 70) autre que sur le qubit à adresser (54, 56, 58, 60, 62, 64, 66, 68, 70), dans lequel des structures électriquement conductrices (74, 76, 78, 86, 88, 90) sont disposées dans des plans (80, 92) différents, dans lequel les structures électriquement conductrices (74, 76, 78, 86, 88, 90) de différents plans (80, 92) sont disposées de manière oblique les unes par rapport aux autres, dans lequel les qubits (54, 56, 58, 60, 62, 64, 66, 68, 70) se trouvent par rapport à une projection sur les plans (80, 92) à proximité de points d'intersection de premiers fils (74, 76, 78, 86, 88, 90), dans lequel les qubits (54, 56, 58, 60, 62, 64, 66, 68, 70) sont présents dans une couche en diamant (52) en tant que matériau environnant, dans lequel le matériau environnant est dopé au soufre, au phosphore ou à l'oxygène, dans lequel les qubits (54, 56, 58, 60, 62, 64, 66, 68, 70) sont formés par des centres NV en diamant (52).

6. Dispositif selon la revendication 5, **caractérisé en ce que** le dispositif est adapté pour mettre en œuvre le procédé selon l'une quelconque des revendications 1 à 4.

7. Dispositif selon la revendication 5 ou 6, **caractérisé en ce que** le dispositif présente des sources électromagnétiques (74, 76, 78, 86, 88, 90), de manière préférée des premières structures électriquement conductrices, en particulier des câbles, des fils (74, 76, 78, 86, 88, 90) ou des métallisations, pour générer les champs électromagnétiques et les contre-champs électromagnétiques, dans lequel au moins une source électromagnétique est associée à chaque qubit (54, 56, 58, 60, 62, 64, 66, 68, 70).

8. Dispositif selon la revendication 7, **caractérisé en ce que** plusieurs sources électromagnétiques (74, 76, 78, 86, 88, 90) sont disposées dans un plan, dans lequel les qubits (54, 56, 58, 60, 62, 64, 66, 68, 70) présentent une distance de manière perpendiculaire audit plan par rapport à la source électromagnétique respectivement associée de 30 nm au maximum, de manière préférée de 20 nm au maximum, en particulier dans la plage de 0 nm à 10 nm,
et/ou
dans lequel les qubits (54, 56, 58, 60, 62, 64, 66, 68, 70) présentent, de manière projetée sur ledit plan, une distance par rapport à la source électromagnétique (74, 76, 78, 86, 88, 90) respectivement associée de 20 nm au maximum, de manière préférée de 10 nm au maximum, en particulier dans la plage de 0 nm à 5 nm.

9. Dispositif selon l'une quelconque des revendications 7 ou 8, **caractérisé en ce qu'**au moins une première structure électriquement conductrice (74, 76, 78, 86, 88, 90) peut être reliée au choix à une excitation électromagnétique et à une détection de photoélectrons.

10. Dispositif selon l'une quelconque des revendications 7 à 9, **caractérisé en ce qu'**au moins une deuxième structure électriquement conductrice (94), de manière préférée un deuxième fil électriquement conducteur, un câble ou une métallisation ou une électrode (94) sont disponibles, qui forme la mise à la terre pour la lecture des qubits (54, 56, 58, 60, 62, 64, 66, 68, 70), dans lequel la deuxième structure électriquement conductrice est disposée de manière préférée de manière adjacente à une première source électromagnétique, en particulier à une distance dans un plan de 40 nm au maximum, de manière préférée de 30 nm au maximum, en particulier dans une plage de 10 nm à 20 nm.

11. Dispositif selon l'une quelconque des revendications 7 à 10, **caractérisé en ce que** les premières structures électriquement conductrices (74, 76, 78, 86, 88, 90) et/ou les deuxièmes structures électriquement conductrices
i) présentent une section transversale avec une dimension longitudinale inférieure à 50 nm, de manière préférée inférieure à 20 nm, en particulier dans la plage de 1 nm à 10 nm, et/ou
ii) présentent une longueur inférieure à 50 nm, de manière préférée inférieure à 30 nm, en particulier de 5 nm à 20 nm.

12. Dispositif selon l'une quelconque des revendications 5 à 11, **caractérisé en ce que** les qubits (54, 56, 58, 60, 62, 64, 66, 68, 70) sont disposés de manière mono-, bi- ou tridimensionnelle, et/ou
**que** les structures électriquement conductrices (74, 76, 78, 86, 88, 90) sont disposées de manière mono-, bi- ou tridimensionnelle, dans lequel de manière préférée deux plans ou plus (80, 92) sont disponibles, dans lesquels des structures électriquement conductrices (74, 76, 78, 86, 88, 90) sont disposées, en particulier de manière parallèle les unes par rapport aux autres, dans lequel les structures électriquement conductrices (74, 76, 78, 86, 88, 90) de différents plans (80, 92) sont disposées différemment, dans lequel de préférence un isolant électrique (82) est disposé entre deux plans (80, 92).

13. Procédé de fabrication d'un dispositif selon l'une quelconque des revendications 5 à 12, **caractérisé en ce que** deux ou plusieurs qubits (54, 56, 58, 60, 62, 64, 66, 68, 70) sont générés dans un matériau environnant et des premiers fils électriquement conducteurs (74, 76, 78, 86, 88, 90) sont disposés sur le matériau environnant, dans lequel une couche en diamant (52) est choisie en tant que le matériau environnant et le matériau environnant est dopé au soufre, au phosphore ou à l'oxygène.

14. Procédé selon la revendication 13, **caractérisé en ce qu'**en supplément au moins une des étapes suivantes est mise en œuvre :
- la mise en œuvre d'une première étape de thermorégulation après le dopage,
- la mise en œuvre d'une deuxième étape de thermorégulation après la génération des qubits (54, 56, 58, 60, 62, 64, 66, 68, 70),
- l'installation de deuxièmes fils électriquement conducteurs pour lire les qubits (54, 56, 58, 60, 62, 64, 66, 68, 70).
